# EUROPEAN PATENT SPECIFICATION

(11) **EP 4 407 689 B1**
(45) Date of publication and mention of the grant of the patent: **25.03.2026**
(21) Application number: 21965957.0
(22) Date of filing: 30.11.2021
(51) Int. Cl.: H10D 30/47, H10D 64/00, H10D 64/27, H10D 30/01, H10D 62/85

(54) **SEMICONDUCTOR DEVICE AND ELECTRONIC APPARATUS**
HALBLEITERBAUELEMENT UND ELEKTRONISCHE VORRICHTUNG
DISPOSITIF À SEMI-CONDUCTEUR ET APPAREIL ÉLECTRONIQUE

(43) Date of publication of application: 31.07.2024
(73) Proprietor: Huawei Technologies Co., Ltd., Shenzhen, Guangdong 518129 (CN)
(72) Inventor: LE, Lingcong, Shenzhen, Guangdong 518129 (CN); ZHONG, Zheng, Shenzhen, Guangdong 518129 (CN); LI, Haijun, Shenzhen, Guangdong 518129 (CN); HU, Huilan, Shenzhen, Guangdong 518129 (CN); MA, Ping, Shenzhen, Guangdong 518129 (CN)
(74) Representative: MERH-IP Matias Erny Reichl Hoffmann Patentanwälte PartG mbB
(86) International application number: PCT/CN2021/134648
(87) International publication number: WO 2023/097520

(56) References cited:
- CN-A- 103 367 403
- CN-A- 105 322 005
- JP-A- 2007 073 815
- JP-B2- 5 899 803
- US-A1- 2016 322 351
- ANDO Y., WAKEJIMA A., OKAMOTO Y., NAKAYAMA T., OTA K., YAMANOGUCHI K., MURASE Y., KASAHARA K., MATSUNAGA K., INOUE T., MIYAMOTO H.: "Novel AlGaN/GaN dual-field-plate FET with high gain, increased linearity and stability", INTERNATIONAL ELECTRON DEVICES MEETING 5-7.12.2005, IEEE, IEEE, PISCATAWAY, NJ. USA, 5 December 2005 (2005-12-05), IEEE, Piscataway, NJ. USA , pages 576 - 579, XP010903543, ISBN: 978-0-7803-9268-7, DOI: 10.1109/IEDM.2005.1609412

## Description

### TECHNICAL FIELD

This application relates to the field of semiconductor technologies, and in particular, to a semiconductor component and an electronic device.

### BACKGROUND

With development of semiconductor technologies, semiconductor components with a high thermal conductivity, a high electron drift velocity, high temperature resistance, and stable chemical properties are widely used in the high frequency, high temperature, and microwave fields.

It is found through research that how to increase a working voltage of the semiconductor component to effectively improve a microwave power characteristic of the semiconductor component is an important challenge in the semiconductor field at present.

Document JP 2013098222A relates to a nitride semiconductor device comprising a gate field plate electrically connected to the gate electrode and arranged on an insulation film between the gate electrode and the drain electrode, and a source field plate electrically connected to the source electrode and positioned above the gate field plate and the drain electrode, facing the nitride semiconductor layer across an insulation film.

Document JP 2007073815A relates to a semiconductor device in which the length of a source-side roof of a first gate (nearest to a source electrode) and the length of a drain-side pent roof of a third gate (nearest to a drain electrode) are longer than the lengths of other pent roofs in a gate electrode. Document US 2016322351A1 relates to a symmetric, bidirectional HEMT with two gates comprising T-shaped gate field plates as well as two further field plates extending from the centre of the device (i.e. the channel facing side) over the channel facing portion of the gate field plates without fully extending over the gates and the respective portions of the gate field plates that face the respective S/D electrodes. The field plate closest to the source is electrically connected to the source and the field plate closest to the drain is electrically connected to the drain.

### SUMMARY

The present invention is defined by the appended claims. In the following, parts of the description and drawings referring to former embodiments which do not necessarily comprise all features to implement embodiments of the claimed invention are understood to not represent embodiments of the invention but to relate to examples useful for understanding the embodiments of the invention. Embodiments of this application provide a semiconductor component and an electronic device, to increase a working voltage of the semiconductor component.

To achieve the foregoing objective, the following technical solutions are used in this application.

According to a first aspect of embodiments of this application, a semiconductor component is provided. The semiconductor component may be, for example, a high-electron-mobility transistor component. The semiconductor component includes: a substrate; a channel layer and a barrier layer that are sequentially stacked on the substrate; a source and a drain that are disposed on the barrier layer; a first gate and a second gate that are disposed on the barrier layer, where the first gate and the second gate are located between the source and the drain, and the second gate is disposed between the first gate and the drain; a first gate field plate that is at least partially disposed on a side that is of the first gate and that is close to the drain; a second gate field plate is at least partially disposed on a side that is of the second gate and that is close to the drain; a first source field plate, where the first source field plate is electrically connected to the source and covers the first gate field plate, and the first source field plate overlaps the first gate and does not cover the first gate, or the first source field plate does not overlap the first gate;. and a second source field plate is electrically connected to the source and covers the second gate field plate.

In this embodiment of this application, the first gate field plate and the first source field plate are disposed in the semiconductor component, so that electric field distribution between the first gate and the drain can be changed, and an electric field strength on the side that is of the first gate and that is close to the drain is reduced. Therefore, a possibility of breakdown of a material of the barrier layer can be reduced, a breakdown voltage of the semiconductor component can be increased, and a working voltage of the semiconductor component can be increased. On this basis, the second gate is disposed between the first gate and the drain, and the second gate can reduce feedback paths between the first gate and the drain, to achieve shielding effect to some extent, reduce a gate-drain parasitic capacitance between the first gate and the drain, reduce impact of the gate-drain parasitic capacitance on performance of the semiconductor component, increase the working voltage of the semiconductor component, and reduce impact on other performance of the semiconductor component.

The second gate field plate is disposed in the semiconductor component, so that an electric field strength of a region near the second gate can be significantly reduced. Therefore, the possibility of breakdown of the material of the barrier layer can be reduced, the breakdown voltage of the semiconductor component can be further increased, and performance of the semiconductor component can be ensured. In addition, the second gate field plate is disposed in the semiconductor component, and the second gate field plate can achieve the shielding effect to some extent, and further extend a depletion region, to reduce the gate-drain parasitic capacitance between the first gate and the drain.

When the second source field plate is disposed in the semiconductor component, a conductive structure of the second source field plate may adjust electric field distribution between the second gate field plate and the drain, to reduce an electric field strength on the side that is of the second gate and that is close to the drain, reduce a peak electric field of the semiconductor component, and further increase the breakdown voltage of the semiconductor component.

In a possible implementation, the first source field plate covers the second gate field plate. The first source field plate may overlap the second gate. In this way, even if a spacing between the first gate and the second gate is reduced, difficulty of a process of the first source field plate is not excessively increased, and the process is easy to implement.

In a possible implementation, the first source field plate is connected to the second source field plate. The first source field plate is connected to the second source field plate, so that the first source field plate and the second source field plate may be prepared by using an existing process without changing a preparation process of the first source field plate.

In a possible implementation, there is a gap between the first source field plate and the second source field plate. The gap is provided between the first source field plate and the second source field plate. In comparison with connecting the first source field plate to the second source field plate, this can increase a small signal gain of the semiconductor component.

In a possible implementation, a spacing between the first gate field plate and the second gate ranges from 0.5 µm to 2.7 µm. The spacing between the first gate field plate and the second gate is shortened, so that a saturation current of the semiconductor component can be significantly increased, to increase power of the semiconductor component. However, a knee-point voltage of the semiconductor component is also increased, and consequently, efficiency of the semiconductor component is reduced. In addition, the gate-drain parasitic capacitance of the semiconductor component is increased, and consequently, a gain characteristic of the semiconductor component is reduced. Therefore, the spacing between the first gate field plate and the second gate is set in a range from 0.5 µm to 2.7 µm, so that performance and reliability requirements of the semiconductor component can be comprehensively met.

In a possible implementation, the first gate field plate includes a first part disposed on the side that is of the first gate and that is close to the drain and a second part disposed on a side that is of the first gate and that is close to the source, and the first part and the second part are separately in contact with and connected to the first gate. The first part and the second part of the first gate field plate are respectively disposed on two sides of the first gate. When the first gate and the first gate field plate are prepared, a requirement on alignment boundary precision of the first gate field plate may not be excessively high. Even if alignment is inaccurate, and the first part and the second part obtained through preparation are different in size, impact on a function of the first gate field plate is small. In addition, if the alignment is inaccurate, only sizes of the first part and the second part are affected, and a width of the first gate is not affected. Impact that is on performance of the semiconductor component and that is caused by a change in a size of the first gate can be avoided.

In a possible implementation, the semiconductor component further includes a third gate, and the third gate is disposed between the second gate and the drain. A quantity of gates is further increased, so that the gate-drain parasitic capacitance is further reduced, and the small signal gain of the semiconductor component is increased.

In a possible implementation, the semiconductor component further includes a third gate field plate, and the third gate field plate is at least partially disposed on a side that is of the third gate and that is close to the drain. A quantity of gate field plates is further increased, so that the breakdown voltage of the semiconductor component is further increased.

In a possible implementation, the semiconductor component further includes a third source field plate, and the third source field plate covers the third gate field plate. A quantity of source field plates is further increased, so that the breakdown voltage of the semiconductor component is further increased.

According to a second aspect of embodiments of this application which is an example not covered by the claims but useful for understanding the present application, a semiconductor component is provided. The semiconductor component may be, for example, a high-electron-mobility transistor component. The semiconductor component includes: a substrate; a channel layer and a barrier layer that are sequentially stacked on the substrate; a source and a drain that are disposed on the barrier layer; a first gate and a second gate that are disposed on the barrier layer, where the first gate and the second gate are located between the source and the drain, and the first gate is disposed between the second gate and the drain; a first gate field plate that is at least partially disposed on a side that is of the first gate and that is close to the drain; and a first source field plate, where the first source field plate covers the first gate field plate.

In this embodiment of this application, the first gate field plate and the first source field plate are disposed in the semiconductor component, so that electric field distribution between the second gate and the drain can be changed, and an electric field strength on the side that is of the second gate and that is close to the drain is reduced. Therefore, a possibility of breakdown of a material of the barrier layer can be reduced, a breakdown voltage of the semiconductor component can be increased, and a working voltage of the semiconductor component can be increased. On this basis, the first gate is disposed between the second gate and the drain, and the first gate can reduce feedback paths between the second gate and the drain, to achieve shielding effect to some extent, reduce a gate-drain parasitic capacitance between the second gate and the drain, reduce impact of the gate-drain parasitic capacitance on performance of the semiconductor component, increase the working voltage of the semiconductor component, and reduce impact on other performance of the semiconductor component.

According to a third aspect of embodiments of this application, an electronic device is provided, including a semiconductor component and an antenna. The semiconductor component is configured to amplify a radio frequency signal and output the amplified radio frequency signal to the antenna for radiation. The semiconductor component is the semiconductor component according to any implementation of the first aspect or the second aspect.

The electronic device provided in the third aspect of embodiments of this application includes the semiconductor component according to any implementation of the first aspect or the second aspect, and beneficial effects of the electronic device are the same as beneficial effects of the semiconductor component. Details are not described herein again.

According to a fourth aspect of embodiments of this application which is another example not covered by the claims but useful for understanding the present application, an electronic device is provided, including a semiconductor component and a printed circuit board electrically connected to the semiconductor component. The semiconductor component is the semiconductor component according to any implementation of the first aspect or the second aspect, and a substrate of the semiconductor component is a conductive substrate.

The electronic device provided in the fourth aspect of embodiments of this application includes the semiconductor component according to any implementation of the first aspect or the second aspect, and beneficial effects of the electronic device are the same as beneficial effects of the semiconductor component. Details are not described herein again.

### BRIEF DESCRIPTION OF DRAWINGS

For a more comprehensive understanding of the present invention, reference is now made to the following brief description, in conjunction with the accompanying drawings and detailed description, but the accompanying drawings are not necessarily drawn to scale.
FIG. 1A is a schematic diagram of a structure of an electronic device according to an embodiment of this application;
FIG. 1B is a schematic diagram of a structure of an active antenna unit according to an embodiment of this application;
FIG. 1C is a schematic diagram of a structure of another electronic device according to an embodiment of this application;
FIG. 2A is a schematic diagram of a structure of a semiconductor component according to an embodiment of this application, not falling under the scope of the invention;
FIG. 2B is a schematic diagram of a structure of another semiconductor component according to an embodiment of this application, not falling under the scope of the invention;
FIG. 3 is a schematic diagram of a structure of still another semiconductor component according to an embodiment of this application, not falling under the scope of the invention;
FIG. 4 is a schematic diagram of a structure of still another semiconductor component according to an embodiment of this application, not falling under the scope of the invention;
FIG. 5 is a schematic diagram of a structure of still another semiconductor component according to an embodiment of this application, not falling under the scope of the invention;
FIG. 6A is an output curve diagram of a semiconductor component shown in FIG. 2B according to an embodiment of this application, not falling under the scope of the invention;
FIG. 6B is an output curve diagram of a semiconductor component shown in FIG. 5 according to an embodiment of this application, not falling under the scope of the invention;
FIG. 7A is a schematic diagram of a structure of still another semiconductor component according to an embodiment of this application, not falling under the scope of the invention;
FIG. 7B is a schematic diagram of a structure of still another semiconductor component according to an embodiment of this application, not falling under the scope of the invention;
FIG. 8 is a schematic diagram of a structure of still another semiconductor component according to the invention;
FIG. 9 is a distribution diagram of an electric field at each position of a semiconductor component according to the invention as well as two comparative examples not falling under the scope of the invention;
FIG. 10A is a schematic diagram of a structure of still another semiconductor component according to the invention;
FIG. 10B is a schematic diagram of a structure of still another semiconductor component according to the invention;
FIG. 11A is a schematic diagram of a structure of still another semiconductor component according to the invention;
FIG. 11B is a schematic diagram of a structure of still another semiconductor component according the invention;
FIG. 11C is a schematic diagram of a structure of still another semiconductor component according to the invention;
FIG. 12 is a schematic diagram of a structure of still another semiconductor component according to an embodiment of this application, not falling under the scope of the invention;

Reference numerals:
1: base station; 2: charger; 11: baseband processing unit; 12: active antenna unit; 121: computation unit; 122: first transmission unit; 123: antenna unit; 124: power supply; 1210: control unit; 1211: second transmission unit; 1212: baseband unit; 1213: power supply unit; 1221: RF unit; 1222: PA; 20: substrate; 30: channel layer; 40: barrier layer; 50: nucleation layer; 60: gradient buffer layer; 70: insertion layer; 80: cap layer.

### DESCRIPTION OF EMBODIMENTS

The following describes the technical solutions in embodiments of this application with reference to the accompanying drawings in embodiments of this application. It is clearly that the described embodiments are merely some rather than all of embodiments of this application.

The terms "first" and "second" in embodiments of this application are merely intended for a purpose of description, and shall not be understood as an indication or implication of relative importance or implicit indication of a quantity of indicated technical features. Therefore, a feature limited by "first", "second", or the like may explicitly or implicitly include one or more features. In description of this application, unless otherwise stated, "a plurality of" means two or more than two.

In addition, in embodiments of this application, "up", "down", "left", and "right" are not limited to definitions relative to directions in which parts are schematically placed in accompanying drawings. It should be understood that these directional terms may be relative concepts used for relative description and clarification, and may change correspondingly based on a change of a direction in which a part in an accompanying drawing is placed.

In embodiments of this application, unless otherwise specified in the context, in the entire specification and claims, the term "include" is interpreted as "open and inclusive", that is, "include, but not limited to". In the description of the specification, terms such as "an embodiment", "some embodiments", "example embodiments", "examples", or "some examples" are intended to indicate that specific features, structures, materials, or characteristics related to the embodiments or examples are included in at least one embodiment or example of the present disclosure. The schematic representations of the foregoing terms do not necessarily refer to a same embodiment or example. Moreover, the particular feature, structure, material, or characteristic may be included in any one or more embodiments or examples in any appropriate manner.

When some embodiments are described, expressions of "coupled" and "connected" and their extensions may be used. For example, when some embodiments are described, the term "connected" may be used to indicate that two or more parts are in direct physical contact or electrical contact with each other. For another example, when some embodiments are described, the term "coupled" may be used to indicate that two or more parts are in direct physical contact or electrical contact. However, the term "coupling" may also mean that two or more parts do not directly contact each other, but still collaborate or interact with each other. The embodiments disclosed herein are not necessarily limited to the content of this specification.

In embodiments of this application, an example implementation is described with reference to a sectional view and/or a plane diagram and/or an equivalent circuit diagram that are/is used as an idealized example accompanying drawing. In the accompanying drawings, for clarity, thicknesses of layers and regions are enlarged. Thus, a change in the shape of the drawings, for example, due to manufacturing techniques and/or tolerances, may be envisaged. Therefore, example implementations should not be construed as being limited to the shape of the region shown in this specification, but rather include shape deviations due to, for example, manufacturing. For example, an etching region shown as a rectangle will typically have a bending characteristic. Therefore, the regions shown in the accompanying drawings are essentially examples, and their shapes are not intended to show the actual shape of the region of the device, and are not intended to limit the scope of the example implementations.

In embodiments of this application, the term "two-dimensional electron gas (2DEG)" means that electron movement perpendicular to an interface direction is bound by a potential well and is therefore quantized. Electron movement parallel to a surface is still free. In this case, such free electrons in a two-dimensional direction are referred to as two-dimensional electron gas.

In embodiments of this application, the term "semi-insulating (SI)" means that a resistivity is greater than 10⁵ Ω·cm. For example, a semi-insulating SiC substrate means that a resistivity of the SiC substrate is greater than 10⁵ Ω·cm.

In embodiments of this application, the term "current collapse effect" means effect that when a drain voltage of a semiconductor component exceeds a specific value, a current starts to reduce as the drain voltage increases, and an ideal value cannot be reached.

In embodiments of this application, the term "knee-point voltage" means an inflection point voltage existing when a semiconductor component enters a saturation region from a linear region.

In embodiments of this application, the term "depletion region" means that in a semiconductor pn junction, a Schottky junction, or a heterojunction, an energy band near an interface is bent due to a difference between original chemical potentials of semiconductors on two sides of the interface, to form an interface region with reduced electrons or a reduced hole concentration in a region in which the energy band is bent.

An embodiment of this application provides an electronic device. The electronic device may be, for example, different types of user equipment or terminal devices such as a charger, a small rechargeable household appliance, an uncrewed aerial vehicle, an aerospace device, a lidar driver, a laser, a detector, a radar, and a 5G (the 5^{th} generation mobile network, 5^{th} generation mobile communication technology) communication device. The electronic device may alternatively be a network device such as a base station. Alternatively, the electronic device may be an apparatus such as a power amplifier in the foregoing electronic device. A specific form of the electronic device is not specially limited in embodiments of this application.

In the past 30 years, semiconductor components with a high thermal conductivity, a high electron drift velocity, high temperature resistance, and stable chemical properties have been widely used as radio frequency components or power components in the power electronics field, the microwave radio frequency field, and the photoelectric component field.

For example, a third-generation semiconductor gallium nitride (GaN) material has excellent characteristics, such as a large forbidden band width (3.4 eV), a high breakdown electric field (3.3 MV/cm), a large saturation rate (2.5e7 cm/s), and a high 2DEG density that is at an aluminum gallium nitride (AlGaN)/GaN heterojunction interface and that is caused by polarization effect, so that GaN high-electron-mobility transistor (HEMT) components can work at a high voltage, a high temperature, and a high frequency, and are therefore widely used as the radio frequency components or power components.

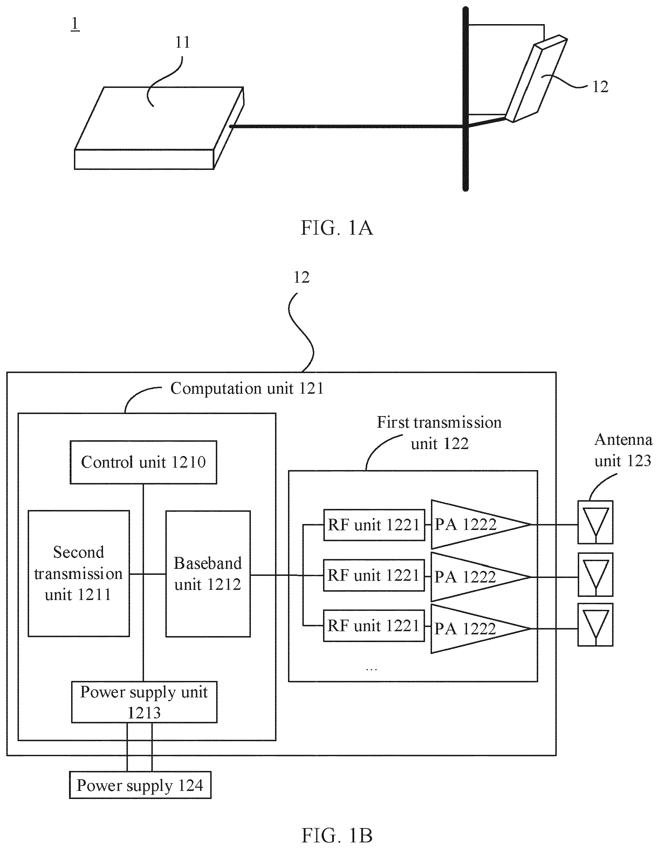

When the semiconductor component is used as the radio frequency component, a structure of the electronic device is described by using an example in which the electronic device is the base station. As shown in FIG. 1A, a base station 1 includes a baseband processing unit (BBU) 11 and an active antenna unit (AAU) 12. The BBU 11 is mainly responsible for baseband digital signal processing, for example, fast Fourier transform (FFT) / inverse fast Fourier transform (IFFT) , modulation/demodulation, and channel encoding/decoding. As shown in FIG. 1B, the AAU 12 includes a computation unit 121, a first transmission unit 122, and an antenna unit 123. The computation unit 121 includes a control unit 1210, a second transmission unit 1211, a baseband unit 1212, and a power supply unit 1213. The control unit 1210, the second transmission unit 1211, the baseband unit 1212, and the power supply unit 1213 are electrically connected to each other. The control unit 1210 is configured to be responsible for control of a radio frequency signal. The second transmission unit 1211 is configured to be responsible for transmission of the radio frequency signal. The baseband unit 1212 is configured to be responsible for conversion between a digital signal and an analog signal. For example, the baseband unit 1212 is a digital to analog converter (DAC) . The DAC may convert, to an analog signal, a digital signal output by the BBU 11. The power supply unit 1213 is electrically connected to a power supply 124, and is configured to supply power to the control unit 1210, the second transmission unit 1211, and the baseband unit 1212 in the computation unit 121. The first transmission unit 122 is configured to be responsible for transmission and amplification of the radio frequency signal. The first transmission unit 122 includes an radio frequency (RF) unit 1221 and a power amplifier (PA) 1222. The RF unit 1221 is configured to convert the analog signal to a low-power radio frequency signal. The PA 1222 is configured to: amplify power of the low-power radio frequency signal, and output the power-amplified radio frequency signal to the antenna unit 123. The antenna unit 123 is responsible for radiating the radio frequency signal. As shown in FIG. 1B, the AAU 12 may include a plurality of RF units 1221, a plurality of PAs 1222, and a plurality of antenna units 123. It should be noted that the PA 1222 may be the semiconductor component.

It should be understood that when the semiconductor component is used as a PA, the electronic device provided in this embodiment of this application is not limited to the base station shown in FIG. 1A and FIG. 1B. Any electronic device that uses the power amplifier to amplify a signal belongs to an application scenario of this embodiment of this application.

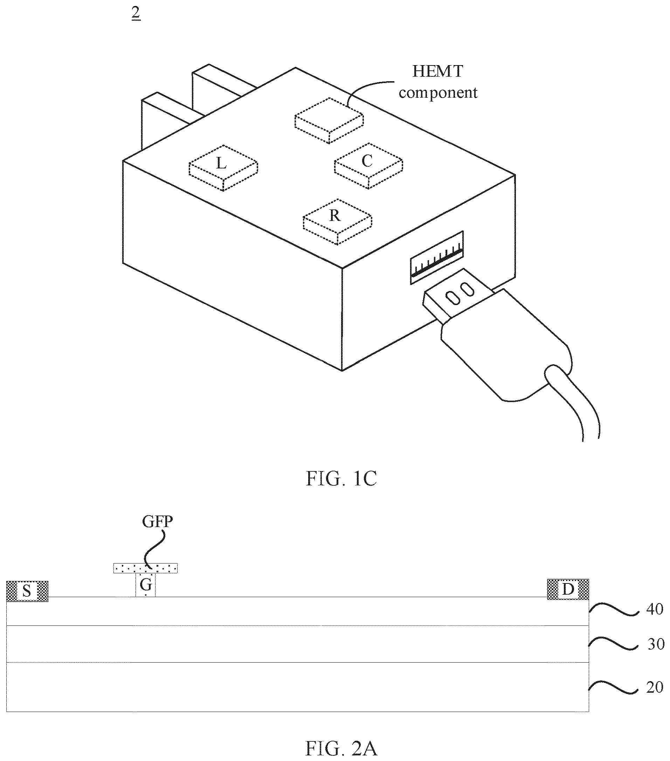

When the semiconductor component is used as the power component, the structure of the electronic device is described by using an example in which the electronic device is the charger. As shown in FIG. 1C, a charger 2 may include a power component, a resistor R, an inductor L, a capacitor C, and the like. The power component may be, for example, the semiconductor component. The semiconductor component, the resistor R, the inductor L, and the capacitor C may be interconnected by using a printed circuit board (PCB).

It should be understood that when the semiconductor component is used as the power component, the electronic device provided in this embodiment of this application is not limited to the charger shown in FIG. 1C. Any electronic device that uses the power component belongs to the application scenario of this embodiment of this application.

A microwave power characteristic of the semiconductor component can be effectively improved by increasing a working voltage of the semiconductor component, and increasing a breakdown voltage of the semiconductor component is a premise for increasing the working voltage of the semiconductor component.

In some embodiments not falling under the scope of the invention, as shown in FIG. 2A, the semiconductor component includes a substrate 20, a channel layer 30 and a barrier layer 40 (which are used as a heterojunction in the semiconductor component) that are disposed on the substrate 20, and a source S, a drain D, and a gate G that are disposed on the barrier layer 40. The source S and the drain D form an ohmic contact with the barrier layer 40, and the gate G forms a Schottky contact with the barrier layer 40. On this basis, the semiconductor component further includes a gate field plate (GFP). A spacing exists between the gate field plate GFP and the barrier layer 40.

When the semiconductor component is in a working state, an electric field is generated between the gate G and the drain D, and a concentration point of the electric field is at a sharp corner that is of the gate G and that is close to the drain D, which easily causes breakdown (irreversible physical damage) of a material of the barrier layer 40, and consequently causes a failure of the semiconductor component. The gate field plate GFP is disposed on the gate G, which means that the gate field plate GFP extends the gate G to a drain D side, so that electric field distribution between the gate G and the drain D can be changed, and the concentration point of the electric field is led to a top corner that is of the gate field plate and that is close to the drain D. The concentration point of the electric field is no longer at the sharp corner that is of the gate G and that is close to the drain D, which means that an electric field strength on a side that is of the gate G and that is close to the drain D is reduced. Although the concentration point of the electric field is located on a side that is of the gate field plate GFP and that is close to the drain D, because the spacing exists between the gate field plate GFP and the barrier layer 40, a possibility of the breakdown of the material of the barrier layer 40 can be reduced, the breakdown voltage of the semiconductor component can be increased, and performance of the semiconductor component can be ensured.

However, a gate-drain parasitic capacitance Cgd (or referred to as a feedback capacitance) exists between the gate G and the drain D. After the gate field plate GFP is disposed, the gate-drain parasitic capacitance Cgd is further increased, which results in a reduction in a small signal gain, a current gain cut-off frequency, and a power gain cut-off frequency of the semiconductor component.

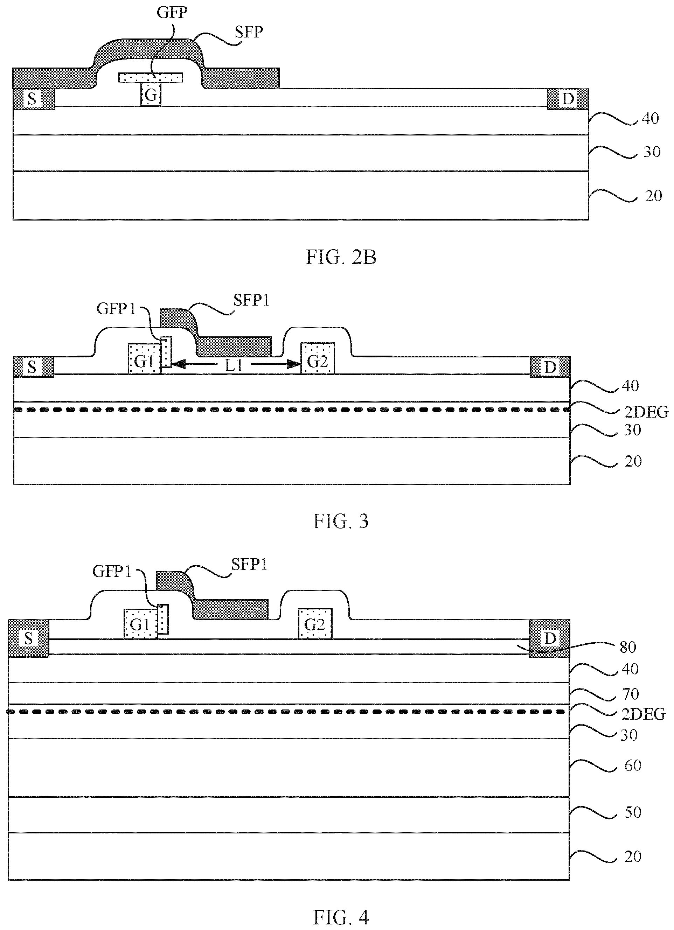

Based on this, in some embodiments not falling under the scope of the invention, as shown in FIG. 2B, the semiconductor component further includes a source field plate (SFP), and the source field plate SFP is disposed on the gate field plate GFP, and overlaps the gate field plate GFP.

The source field plate SFP is disposed in the semiconductor component, so that a feedback path between the gate G and the drain D can be blocked, to reduce the gate-drain parasitic capacitance Cgd of the semiconductor component, and increase the small signal gain, the current gain cut-off frequency, and the power gain cut-off frequency of the semiconductor component. In addition, a conductive structure of the source field plate SFP may adjust electric field distribution between the gate field plate GFP and the drain D, to reduce the electric field strength on the side that is of the gate G and that is close to the drain D, reduce a peak electric field of the semiconductor component, and further increase the breakdown voltage of the semiconductor component. After the electric field strength is reduced, a possibility that an electron is excited by the strong electric field to enter a surface state can be reduced, to suppress current collapse effect of the semiconductor component.

However, introduction of the source field plate SFP increases a gate-source parasitic capacitance Cgs of the semiconductor component, which causes a frequency characteristic of the semiconductor component to deteriorate.

In some embodiments, to improve a gain characteristic of the semiconductor component, the source field plate SFP is extended to the drain D side.

However, in this manner, extent to which the small signal gain is increased is limited, and in addition, the gate-source parasitic capacitance Cgs of the semiconductor component is significantly increased, which may further reduce drain efficiency of the semiconductor component, and cause the frequency characteristic of the semiconductor component to deteriorate.

In some embodiments, a gate length (a size in a direction from the source S to the drain D) is reduced, to reduce the gate-drain parasitic capacitance Cgd, and further improve the gain characteristic of the semiconductor component. For example, a gate length process with the gate length of 0.25 µm or the gate length of 0.1 µm is used.

However, a shorter gate length requires a higher precision lithography device (for example, an electron beam lithography device) or a more complex process (for example, a linewidth micro-shrinking process). In addition, the shorter gate length may also cause short channel effect, reduce an output impedance of the semiconductor component, and may cause a poor turn-off characteristic in a case of a high leakage voltage.

Therefore, the breakdown voltage, the gain characteristic, and the like of the semiconductor component need to be comprehensively considered during design of the semiconductor component. How to reduce impact on characteristics including the small signal gain, the current gain cut-off frequency, the power gain of the semiconductor component, and the like when reducing the breakdown voltage of the semiconductor component becomes a technical problem that needs to be solved by a person skilled in the art.

The following uses several detailed examples to describe the semiconductor component provided in embodiments of this application.

Example 1 (not falling under the scope of the invention)

This example provides a semiconductor component. As shown in FIG. 3, the semiconductor component mainly includes: a substrate 20, a channel layer 30 and a barrier layer 40 that are sequentially stacked on the substrate 20, a source S and a drain D that are disposed side by side on the barrier layer 40, a first gate G1 and a second gate G2 that are disposed on the barrier layer 40 and located between the source S and the drain D, and a first gate field plate GFP1 and a first source field plate SFP1.

In some embodiments, the substrate 20 is a diamond substrate or a silicon carbide (SiC) substrate.

When the substrate 20 is the SiC substrate, and purity of a raw material is not high, the SiC substrate obtained through growing is a conductive substrate. When the purity of the raw material is high, the SiC substrate obtained through growing is a semi-insulating substrate.

When the substrate 20 is the diamond substrate, the diamond substrate formed through normal growing is a semi-insulating substrate. In a process of forming the diamond substrate, when impurity content is high or the diamond substrate is doped, the formed diamond substrate is a conductive substrate.

When the substrate 20 is the conductive substrate, the semiconductor component is used in an electronic device as a power component, and is interconnected with a PCB in the electronic device. When the substrate 20 is the semi-insulating substrate, the semiconductor component is used in the electronic device as a radio frequency component, and implements signal communication with an antenna in the electronic device.

A thermal conductivity of the diamond substrate is usually 1000 W-m⁻¹·K⁻¹ to 2000 W·m⁻¹·K⁻¹, and a thermal conductivity of the SiC substrate is usually about 370 W·m⁻¹·K⁻¹. When the substrate 20 is the diamond substrate or the SiC substrate, a heat dissipation capability of the substrate 20 is high, so that a heat dissipation capability of the semiconductor component can be improved.

In some embodiments, as shown in FIG. 4, the semiconductor component further includes a nucleation layer 50.

The nucleation layer 50 is disposed on the substrate 20. For example, the nucleation layer 50 is disposed on a surface of the substrate 20.

A method for forming the nucleation layer 50 may be, for example, a metal-organic chemical vapor deposition (MOCVD) growth method or a molecular beam epitaxy (MBE) growth method.

A material of the nucleation layer 50 may include, for example, one or more of GaN, AlGaN, and aluminum nitride (AlN).

A function of the nucleation layer 50 is to match a lattice structure of the substrate 20 with a lattice structure of the channel layer 30. For example, the nucleation layer 50 that has a small lattice structure difference from the substrate 20 may be first placed on the substrate 20, and then the channel layer 30 that has a small lattice structure difference from the nucleation layer 50 is prepared on the nucleation layer 50. The nucleation layer 50 may use a superlattice structure. A repeating unit of the superlattice structure includes two different semiconductor material layers. When thicknesses and cycle lengths of the two semiconductor material layers are less than a mean free path of an electron, quantum size effect may be generated in the superlattice structure. In this case, a well clamped between the two semiconductor material layers of the superlattice structure is a quantum well. Binding effect that an energy potential well generated by the quantum well has on the electron is used, to enable the electron to move in a direction parallel to an interface of the nucleation layer 50, and improve lateral transfer of the electron, so as to avoid or reduce a probability that the electron directly vertically enters the substrate 20 parallel to the interface, so that electric leakage of the substrate 20 is reduced.

In some embodiments, as shown in FIG. 4, the semiconductor component further includes a gradient buffer layer 60.

The gradient buffer layer 60 is disposed on a side that is of the nucleation layer 50 and that is away from the substrate 20. For example, the gradient buffer layer 60 is disposed on a surface that is of the nucleation layer 50 and that is away from the substrate 20.

A method for forming the gradient buffer layer 60 may be, for example, that an MOCVD process is used to epitaxially grow an AlGaN gradient layer whose Al (aluminum) components gradually reduce.

For example, an Al_{0.8}Ga_{0.2}N layer, an Al_{0.5}Ga_{0.5}N layer, and an Al_{0.2}Ga_{0.8}N layer are sequentially formed, by using the MOCVD process, on the side that is of the nucleation layer 50 and that is away from the substrate 20, to form the gradient buffer layer 60.

In addition, it may be understood that, compositions, of the gradient buffer layer 60, existing when the semiconductor component is used as the radio frequency component may be different from compositions, of the gradient buffer layer 60, existing when the semiconductor component is used as the power component.

A function of the gradient buffer layer 60 is that, because a forbidden band width of the gradient buffer layer 60 is different from a forbidden band width of the channel layer 30, a potential well of a heterojunction including the barrier layer 40 and the channel layer 30 can be deeper, to increase a two-dimensional electron gas (2DEG) concentration. In addition, to reduce a decrease in mobility caused by electron scattering, the gradient buffer layer 60 usually uses an undoped structure.

In some embodiments, as shown in FIG. 3 and FIG. 4, the channel layer 30 is disposed on the substrate 20.

For example, as shown in FIG. 3, the channel layer 30 is disposed on the surface of the substrate 20. Alternatively, as shown in FIG. 4, the channel layer 30 is disposed on a surface of the gradient buffer layer 60.

A method for forming the channel layer 30 may be, for example, the MOCVD growth method or the MBE growth method.

A material of the channel layer 30 may include, for example, one or more of GaN, AlGaN, indium aluminum nitride (InAlN), AlN, and scandium aluminum nitride (ScAlN).

In some embodiments, as shown in FIG. 4, the semiconductor component further includes an insertion layer 70.

The insertion layer 70 is disposed on the channel layer 30. For example, the insertion layer 70 is disposed on a surface of the channel layer 30.

A method for forming the insertion layer 70 may be, for example, the MOCVD growth method or the MBE growth method.

The insertion layer is disposed between the channel layer 30 and the barrier layer 40, so that the 2DEG concentration can be increased.

In some embodiments, as shown in FIG. 3 and FIG. 4, the barrier layer 40 is disposed on the channel layer 30.

For example, as shown in FIG. 3, the barrier layer 40 is disposed on the surface of the channel layer 30. Alternatively, for example, the barrier layer 40 is disposed on a surface of the insertion layer 70.

A method for forming the barrier layer 40 may be, for example, the MOCVD growth method or the MBE growth method.

A material of the barrier layer 40 may include, for example, one or more of GaN, AlGaN, InAlN, AlN and ScAlN.

It may be understood that the channel layer 30 and the barrier layer 40 form the heterojunction of the semiconductor component, and two-dimensional electron gas is generated above the channel layer 30. Therefore, the material of the channel layer 30 is different from the material of the barrier layer 40. For example, the material of the channel layer 30 includes GaN, and the material of the barrier layer 40 includes AlGaN.

In some embodiments, as shown in FIG. 4, the semiconductor component further includes a cap layer 80.

The cap layer 80 is disposed on the barrier layer 40. For example, the cap layer 80 is disposed on a surface of the barrier layer 40.

A method for forming the cap layer 80 may be, for example, that the cap layer may be formed by using the MOCVD growth method or the MBE growth method in combination with an etching process.

The cap layer 80 has an opening (a position at which the source S and the drain D are disposed) for disposing the source S and the drain D, and the opening exposes the barrier layer 40.

A material of the cap layer 80 may be, for example, GaN or silicon nitride (Si₃N₄).

The cap layer 80 is formed on the barrier layer 40, so that the barrier layer 40 can be protected, the surface of the barrier layer 40 is not oxidized, and surface states of the semiconductor component can be reduced. That is, an on-resistance of the semiconductor component is reduced, to reduce electric leakage and power consumption of the gate of the semiconductor component, and improve reliability of the semiconductor component.

In some embodiments, as shown in FIG. 4, when the opening on the cap layer 80 is formed through etching, a small amount of etching may be performed on the barrier layer 40. In other words, finally, there is a recess on the barrier layer 40.

In this way, the source S, the drain D, and the recess on the barrier layer 40 may form a new ohmic contact surface, which facilitates diffusion of TiN (titanium nitride) formed between the source S and the drain D and the surface of the barrier layer 40, to form a second conductive channel, and effectively reduce an ohmic contact resistance. In addition, using a structure of the recess formed on the barrier layer 40 can effectively increase a maximum current of the drain D, and reduce the on-resistance of the semiconductor component.

In some embodiments, as shown in FIG. 3 and FIG. 4, the source S and the drain D are disposed on the barrier layer 40 and located in the opening on the cap layer 80, to form an ohmic contact with the barrier layer 40.

The source S and the drain D may be formed, for example, by using photolithography and etching processes, and the source S and the drain D may be, for example, formed synchronously.

Materials of the source S and the drain D may be, for example, a titanium (Ti) layer, an Al layer, a nickel (Ni) layer, and a gold (Au) layer that are sequentially stacked, that is, Ti/Al/Ni/Au. Alternatively, materials of the source S and the drain D may be a Ti layer, an Al layer, a platinum (Pt) layer, and an Au layer that are sequentially stacked, that is, Ti/Al/Pt/Au. Alternatively, materials of the source S and the drain D may be a Ti layer, a tantalum (Ta) layer, and a Ti layer that are sequentially stacked, that is, Ti/Ta/Ti. Alternatively, materials of the source S and the drain D may be Au or palladium (Pd).

In some embodiments, as shown in FIG. 3 and FIG. 4, the first gate G1 and the second gate G2 are disposed on the barrier layer 40, and located between the source S and the drain D.

For example, as shown in FIG. 3, the first gate G1 and the second gate G2 are disposed on the surface of the barrier layer 40, and form a Schottky contact with the barrier layer 40. Alternatively, for example, as shown in FIG. 4, the first gate G1 and the second gate G2 are disposed on a surface of the cap layer 80, and form a Schottky contact with the barrier layer 40.

The first gate G1 and the second gate G2 may be formed, for example, by using the photolithography and etching processes, and the first gate G1 and the second gate G2 may be, for example, formed synchronously.

Materials of the first gate G1 and the second gate G2 may be, for example, Au or Pd.

In this example, as shown in FIG. 3 and FIG. 4, the first gate G1 is disposed close to the source S, and the second gate G2 is disposed close to the drain D. In other words, the first gate G1 is disposed between the source S and the second gate G2.

In some embodiments, a spacing L1 between the first gate field plate GFP1 and the second gate G2 ranges from 0.5 µm to 2.7 µm.

For example, the spacing L1 between the first gate field plate GFP1 and the second gate G2 is 0.7 µm, 1.0 µm, 1.3 µm, 1.5 µm, 1.7 µm, 2.0 µm, 2.3 µm, or 2.5 µm.

The spacing L1 between the first gate field plate GFP1 and the second gate G2 is shortened, so that a saturation current of the semiconductor component can be significantly increased, to increase power of the semiconductor component. However, a knee-point voltage of the semiconductor component is also increased, and consequently, efficiency of the semiconductor component is reduced. In addition, a gate-drain parasitic capacitance Cgd of the semiconductor component is increased, and consequently, the gain characteristic of the semiconductor component is reduced. Therefore, the spacing L1 between the first gate field plate GFP1 and the second gate G2 is set in a range from 0.5 µm to 2.7 µm, so that performance and reliability requirements of the semiconductor component can be comprehensively met.

In some embodiments, as shown in FIG. 3 and FIG. 4, the first gate field plate GFP1 is at least partially located on a side that is of the first gate G1 and that is close to the drain D, the first gate field plate GFP1 is electrically connected to the first gate G1, and a spacing exists between the first gate field plate GFP1 and the barrier layer 40.

For example, as shown in FIG. 3 and FIG. 4, the first gate field plate GFP1 includes only a part located on the side that is of the first gate G1 and that is close to the drain D, and the first gate field plate GFP1 is in contact with and connected to the first gate G1.

For example, the first gate field plate GFP1 and the first gate G1 are of an integrally formed structure, and are synchronously formed in a same preparation process.

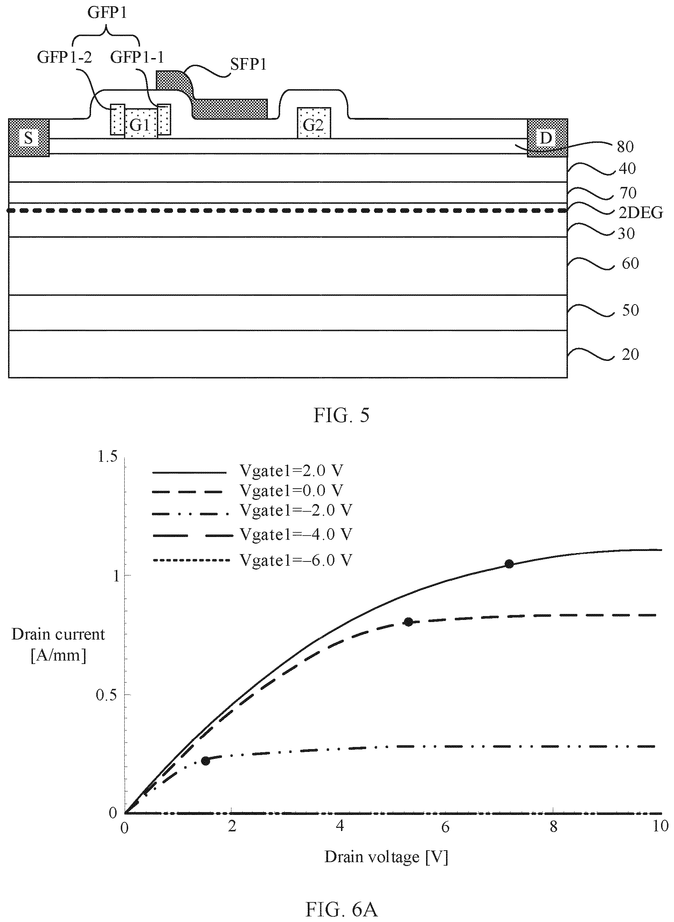

Alternatively, for example, as shown in FIG. 5, the first gate field plate GFP1 includes a first part GFP1-1 located on the side that is of the first gate G1 and that is close to the drain D and a second part GFP1-2 located on a side that is of the first gate G1 and that is close to the source S. The first part GFP1-1 and the second part GFP1-2 of the first gate field plate GFP1 are both in contact with and connected to the first gate G1.

For example, the first part GFP1-1 and the second part GFP1-2 of the first gate field plate GFP1 and the first gate G1 are of an integrally formed structure, and are synchronously formed in a same preparation process.

The first part GFP1-1 and the second part GFP1-2 of the first gate field plate GFP1 are respectively disposed on two sides of the first gate G1. When the first gate G1 and the first gate field plate GFP1 are prepared, a requirement on alignment boundary precision of the first gate field plate GFP1 may not be excessively high. Even if alignment is inaccurate, and the first part GFP1-1 and the second part GFP1-2 obtained through preparation are different in size, impact on a function of the first gate field plate GFP1 is small. In addition, if the alignment is inaccurate, only sizes of the first part GFP1-1 and the second part GFP1-2 are affected, and a width of the first gate G1 is not affected. Impact that is on performance of the semiconductor component and that is caused by a change in a size of the first gate G1 can be avoided.

A shape of the first gate field plate GFP1 is not limited in this embodiment of this application. A shape of the gate field plate shown in FIG. 3, FIG. 4, and FIG. 5 is merely an example.

In some embodiments, as shown in FIG. 3, FIG. 4, and FIG. 5, the first source field plate SFP1 is disposed on a side that is of the first gate field plate GFP1 and that is away from the substrate 20, and the first source field plate SFP1 is electrically connected to the source S.

Certainly, one or more inter-layer dielectric layers may be disposed, as needed, between the first source field plate SFP1 and the first gate field plate GFP1, and the first source field plate SFP1 is electrically connected to the source S through a via hole on the inter-layer dielectric layer.

According to different sizes of the first gate G1 and the second gate G2, as shown in FIG. 3, a side that is of the first source field plate SFP1 and that is away from the first gate field plate GFP1 is located between the first gate G1 and the second gate G2. Alternatively, a side that is of the first source field plate SFP1 and that is away from the first gate field plate GFP1 overlaps the second gate G2.

The first source field plate SFP1 covers the first gate field plate GFP1. In other words, in a direction perpendicular to the substrate 20 (or understood as a thickness direction of the substrate 20), the first source field plate SFP1 overlaps the first gate field plate GFP1.

For example, in the direction perpendicular to the substrate 20 (or understood as the thickness direction of the substrate 20), a side that is of the first source field plate SFP1 and that is close to the first gate field plate GFP1 overlaps the first gate field plate GFP1.

Alternatively, it is understood as that, on the side close to the first gate field plate GFP1, an orthographic projection of the first source field plate SFP1 on the substrate 20 overlaps an orthographic projection of the first gate field plate GFP1 on the substrate 20.

In some embodiments, the first source field plate SFP1 overlaps the first gate G1, but the first source field plate SFP1 does not cover the first gate G1. Alternatively, in some embodiments, the first source field plate SFP1 does not overlap the first gate G1.

Alternatively, it is understood as that a side that is of the first source field plate SFP1 and that is close to the first gate G1 does not extend above the first gate G1.

The first source field plate SFP1 is disposed only on a side that is of the first gate field plate GFP1 and that is close to the drain D, so that a directly facing area between the first source field plate SFP1 and the first gate G1 can be reduced, to reduce a gate-source parasitic capacitance Cgs of the semiconductor component, and reduce impact of the first source field plate SFP1 on the frequency characteristic of the semiconductor component.

In some embodiments, the first source field plate SFP1 is in contact with and connected to the source S to implement an electrical connection between the first source field plate SFP1 and the source S. The first source field plate SFP1 may bypass the first gate G1 to be in contact with and connected to the source S.

A material of the first source field plate SFP1 may be, for example, the same as the materials of the source S and the drain D. During preparation of the semiconductor component, if the first gate G1 and the second gate G2 are first formed, and then the source S and the drain D are formed, the first source field plate SFP1 may be, for example, formed synchronously with the source S and the drain D.

Certainly, a structure such as a dielectric layer or a flat layer may be disposed, as needed, on a side that is of the first source field plate SFP1 and that is away from the substrate 20. This is not limited in this embodiment of this application.

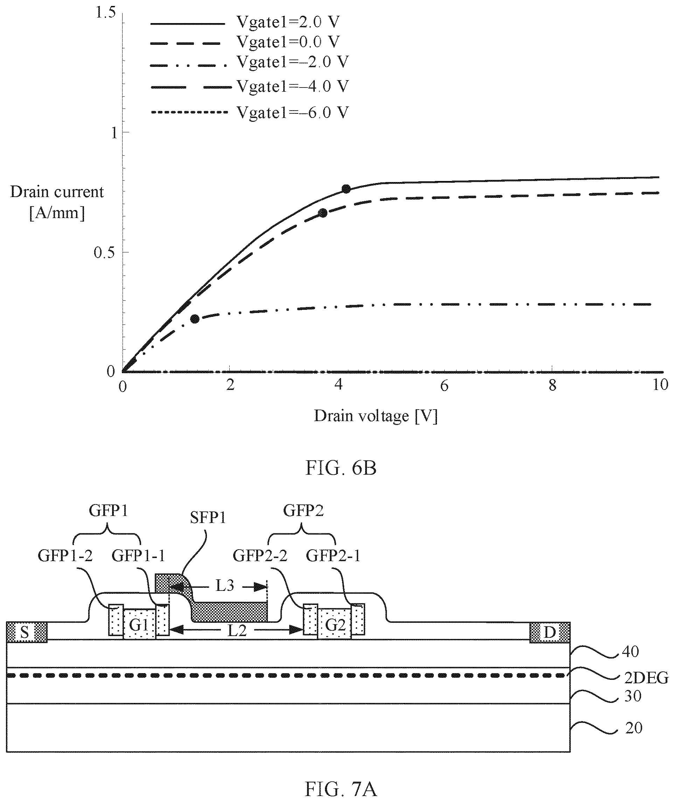

The semiconductor component provided in this example includes the first gate G1 and the second gate G2. When the semiconductor component works, the first gate G1 is configured to receive a drive signal Vgate1 and a radio frequency signal RF, and the second gate G2 is configured to receive a fixed voltage signal Vgate2. Based on this, FIG. 6A is an output curve diagram of the single-gate semiconductor component shown in FIG. 2B, and FIG. 6B is an output characteristic curve of the dual-gate semiconductor component shown in FIG. 3. It can be found by comparing FIG. 6A and FIG. 6B that, in FIG. 6B, when a drain D voltage is low, an output voltage of the semiconductor component has reached a saturation state (a black dot in the figure represents the knee-point voltage). Therefore, the knee-point voltage of the semiconductor component provided in this example is significantly lower than a knee-point voltage of the semiconductor component shown in FIG. 2B. In FIG. 6A and FIG. 6B, a horizontal axis represents drain D voltages, and a vertical axis represents drain D currents. FIG. 6A and FIG. 6B are simulations performed when the fixed voltage signal Vgate2 received by the second gate G2 has a fixed value (for example, 2 V). Different curves are curves when the first gate G1 receives different drive signals Vgate1. When the Vgate1 is -4.0 V and the Vgate1 is -6.0 V, the output curve basically coincides with the horizontal axis.

**Table 1**

| Description | Solution | Saturation current | Knee-point voltage | Small signal gain | Cgd |
|---|---|---|---|---|---|
| G1 | Structure in FIG. 2B | 1.09 A | 7.2 V | 24.9 dB | 0.023 pF |
| G1+G2 | Structure in FIG. 3 | 0.82 A | 4.0 V | 30.1 dB | 0.009 pF |

As shown in Table 1, when the Vgate2 applied to the second gate G2 is 2 V and the spacing L1 between the first gate field plate GFP1 and the second gate G2 is 1.7 µm, it is found through simulation that disposing the second gate G2 in the semiconductor component can change distribution of carriers in a channel, and reduce a carrier concentration, to reduce a current of the semiconductor, reduce the knee-point voltage of the semiconductor component, and improve the efficiency of the semiconductor component. As shown in FIG. 6B, a smaller Vgate1 indicates a lower knee-point voltage of the semiconductor component. In addition, the second gate G2 is disposed between the first gate G1and the drain D, so that the second gate G2 can block a feedback path between the first gate G1 and the drain D, and the second gate G2 can achieve shielding effect to some extent, to reduce the gate-drain parasitic capacitance Cgd between the first gate G1 and the drain D (the gate-drain parasitic capacitance Cgd may be reduced to 1/3 to 1/2 of that of the semiconductor component shown in FIG. 2B) when the semiconductor component is in an off state (for example, a bias is applied, a voltage of the first gate G1 is -6 V, and the drain voltage is 50 V, so that the semiconductor component is in the off state), and increase the small signal gain of the semiconductor component (the small signal gain may be increased by about 5 dB in comparison with that of the semiconductor component shown in FIG. 2B), and a current gain cut-off frequency, and a power gain cut-off frequency.

Example 2 (not falling under the scope of the invention)

A main difference between Example 2 and Example 1 lies in that, on the basis of the semiconductor component structure in Example 1, a semiconductor component in Example 2 further includes a second gate field plate GFP2.

As shown in FIG. 7A, the semiconductor component is provided, and the semiconductor component mainly includes: a substrate 20, a channel layer 30 and a barrier layer 40 that are sequentially stacked on the substrate 20, a source S and a drain D that are disposed side by side on the barrier layer 40, a first gate G1 and a second gate G2 that are disposed on the barrier layer 40 and located between the source S and the drain D, a first gate field plate GFP1 and the second gate field plate GFP2, and a first source field plate SFP1.

The second gate field plate GFP2 is at least partially located on a side that is of the second gate G2 and that is close to the drain D. The second gate field plate GFP2 is electrically connected to the second gate G2, and a spacing exists between the second gate field plate GFP2 and the barrier layer 40.

For example, the second gate field plate GFP2 includes only a part that is located on the side that is of the second gate G2 and that is close to the drain D, and the second gate field plate GFP2 is in contact with and connected to the second gate G2.

For example, the second gate field plate GFP2 and the second gate G2 are of an integrally formed structure, and are synchronously formed in a same preparation process.

Alternatively, for example, as shown in FIG. 7A, the second gate field plate GFP2 includes a first part GFP2-1 located on the side that is of the second gate G2 and that is close to the drain D and a second part GFP2-2 located on a side that is of the second gate G2 and that is close to the source S. The first part GFP2-1 and the second part GFP2-2 of the second gate field plate GFP2 are both in contact with and connected to the second gate G2.

For example, the first part GFP2-1 and the second part GFP2-2 of the second gate field plate GFP2 and the second gate G2 are of an integrally formed structure, and are synchronously formed in a same preparation process.

A shape of the second gate field plate GFP2 is not limited in this embodiment of this application. A shape of the second gate field plate GFP2 shown in FIG. 7A is merely an example.

In some embodiments, as shown in FIG. 7A, a value of a spacing L2 between the first gate field plate GFP1 and the second gate field plate GFP2 ranges from 0.5 µm to 2.5 µm. For example, the spacing L2 between the first gate field plate GFP1 and the second gate field plate GFP2 is 0.7 µm, 1.0 µm, 1.3 µm, 1.5 µm, 1.7 µm, 2.0 µm, or 2.3 µm.

In this example, the spacing L2 between the first gate field plate GFP1 and the second gate field plate GFP2 is greater than a length L3 of a part that is of the first source field plate SFP1 and that is located between the first gate field plate GFP1 and the second gate field plate GFP2.

In this example, structures of the substrate 20, the channel layer 30 and the barrier layer 40, the source S and the drain D, the first gate G1 and the second gate G2, the first gate field plate GFP1, and the first source field plate SFP1 are the same as those in Example 1. For details, refer to related descriptions in Example 1. Details are not described herein again.

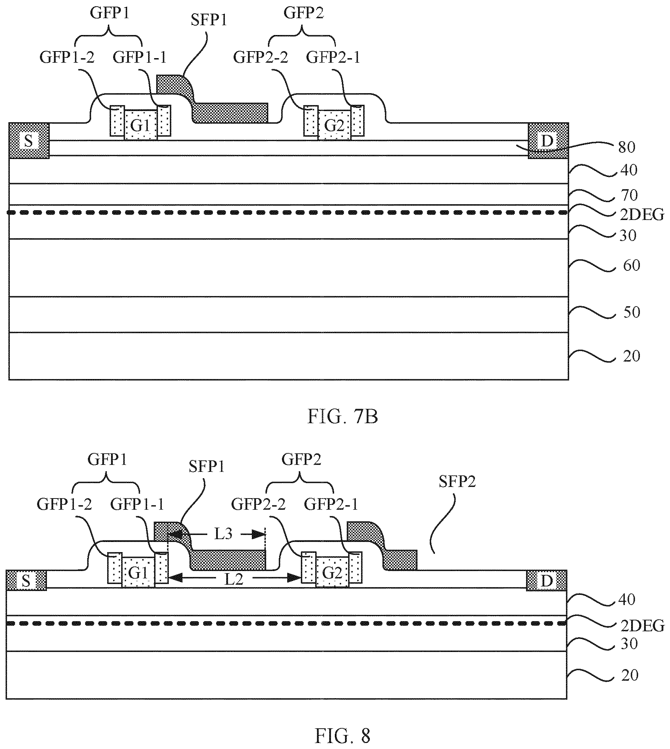

In some embodiments, as shown in FIG. 7B, the semiconductor component further includes a nucleation layer 50, a gradient buffer layer 60, an insertion layer 70, and a cap layer 80. Structures of the nucleation layer 50, the gradient buffer layer 60, the insertion layer 70, and the cap layer 80 are the same as those in Example 1. For details, refer to related descriptions in Example 1. Details are not described herein again.

As shown in Table 2, when Vgate2 applied to the second gate G2 is 2 V and the spacing L2 between the first gate field plate GFP1 and the second gate field plate GFP2 is 1.5 µm, it is found through simulation that disposing the second gate field plate GFP2 in the semiconductor component can significantly reduce an electric field strength of a region near the second gate G2. Therefore, a possibility of breakdown of a material of the barrier layer 40 can be reduced, a breakdown voltage of the semiconductor component can be further increased, and performance of the semiconductor component can be ensured. In addition, the second gate field plate GFP2 is disposed in the semiconductor component, and the second gate field plate GFP2 can achieve shielding effect to some extent, and further extend a depletion region, to reduce a gate-drain parasitic capacitance Cgd between the first gate G1 and the drain D, and increase a small signal gain, a current gain cut-off frequency, and a power gain cut-off frequency of the semiconductor component.

**Table 2**

| Description | Solution | Saturation current | Knee-point voltage | Small signal gain | Cgd |
|---|---|---|---|---|---|
| G1 | Structure in FIG. 2B | 1.09 A | 7.2 V | 24.9 dB | 0.023 pF |
| G1+G2 | Structure in FIG. 3 | 0.82 A | 4.0 V | 30.1 dB | 0.009 pF |
| G1+G2+GFP2 | Structure in FIG. 7A | 0.86 A | 4.8 V | 30.5 dB | 0.007 pF |

### Example 2 (according to the invention)

A main difference between Example 3 and Example 2 lies in that, on the basis of the semiconductor component structure in Example 2, a semiconductor component in Example 3 further includes a second source field plate SFP2.

As shown in FIG. 8, the semiconductor component is provided, and the semiconductor component mainly includes: a substrate 20, a channel layer 30 and a barrier layer 40 that are sequentially stacked on the substrate 20, a source S and a drain D that are disposed side by side on the barrier layer 40, a first gate G1 and a second gate G2 that are disposed on the barrier layer 40 and located between the source S and the drain D, a first gate field plate GFP1 and a second gate field plate GFP2, and a first source field plate SFP1 and the second source field plate SFP2.

The second source field plate SFP2 is disposed on a side that is of the second gate field plate GFP2 and that is away from the substrate 20, and is electrically connected to the source S.

Certainly, one or more inter-layer dielectric layers may be disposed, as needed, between the second source field plate SFP2 and the second gate field plate GFP2. In addition, that the second source field plate SFP2 is electrically connected to the source S may be that the second source field plate SFP2 is directly electrically connected to the source S, or may be that the second source field plate SFP2 is electrically connected to the first source field plate SFP1, to implement an electrical connection between the second source field plate SFP2 and the source S.

The second source field plate SFP2 covers the second gate field plate GFP2. In other words, in a direction perpendicular to the substrate 20 (or understood as a thickness direction of the substrate 20), the second source field plate SFP2 overlaps the second gate field plate GFP2.

For example, in the direction perpendicular to the substrate 20 (or understood as the thickness direction of the substrate 20), a side that is of the second source field plate SFP2 and that is close to the second gate field plate GFP2 overlaps the second gate field plate GFP2.

Alternatively, it is understood as that, on the side close to the second gate field plate GFP2, an orthographic projection of the second source field plate SFP2 on the substrate 20 overlaps an orthographic projection of the second gate field plate GFP2 on the substrate 20.

In some embodiments, the second source field plate SFP2 overlaps the second gate G2, but the second source field plate SFP2 does not cover the second gate G2. Alternatively, in some embodiments, the second source field plate SFP2 does not overlap the second gate G2.

Alternatively, it is understood as that a side that is of the second source field plate SFP2 and that is close to the second gate G2 does not extend above the second gate G2.

The second source field plate SFP2 is disposed only on a side that is of the second gate field plate GFP2 and that is close to the drain D, so that a directly facing area between the second source field plate SFP2 and the second gate G2 can be reduced, to reduce a gate-source parasitic capacitance Cgs of the semiconductor component, and reduce impact of the second source field plate SFP2 on a frequency characteristic of the semiconductor component.

In some embodiments, the second source field plate SFP2 is in contact with and connected to the first source field plate SFP1, to implement an electrical connection between the second source field plate SFP2 and the first source field plate SFP1. The second source field plate SFP2 may bypass the second gate G2 to be in contact with and connected to the first source field plate SFP1.

A material of the second source field plate SFP2 may be, for example, the same as materials of the source S and the drain D. The second source field plate SFP2 may be, for example, formed synchronously with the first source field plate SFP1.

A length of the second source field plate SFP2 (a size in a direction from the source S to the drain D) may be, for example, greater than, less than, or equal to a length of the first source field plate SFP1 (a size in the direction from the source S to the drain D).

A shape of the second source field plate SFP2 is not limited in this embodiment of this application. The second source field plate SFP2 overlaps the second gate G2, and extends to a position between the second gate G2 and the drain D. A shape of the second source field plate SFP2 shown in FIG. 8 is merely an example.

In this example, structures of the substrate 20, the channel layer 30 and the barrier layer 40, the source S and the drain D, the first gate G1 and the second gate G2, the first gate field plate GFP1, the second gate field plate GFP2, and the first source field plate SFP1 are the same as those in Example 1. For details, refer to related descriptions in Example 1. Details are not described herein again.

In some embodiments, the structures of the first gate G1 and the second gate G2 are the same, the structures of the first gate field plate GFP1 and the second gate field plate GFP2 are the same, and the structures of the first source field plate SFP1 and the second source field plate SFP2 are the same. In this way, the structure is simple, and is easy to prepare.

In some embodiments, a value of a spacing L2 between the first gate field plate GFP1 and the second gate field plate GFP2 ranges from 0.5 µm to 1.5 µm.

For example, as shown in FIG. 8, the spacing L2 between the first gate field plate GFP1 and the second gate field plate GFP2 is greater than or equal to a length L3 of a part that is of the first source field plate SFP1 and that is located between the first gate field plate GFP1 and the second gate field plate GFP2. Alternatively, in the direction perpendicular to the substrate 20, the first source field plate SFP1 does not overlap the second gate field plate GFP2.

**Table 3**

| Description | Solution | Saturation current | Knee-point voltage | Small signal gain | Cgd |
|---|---|---|---|---|---|
| G1 | Structure in FIG. 2B | 1.09 A | 7.2 V | 24.9 dB | 0.023 pF |
| G1+G2 | Structure in FIG. 3 | 0.82 A | 4.0 V | 30.1 dB | 0.009 pF |
| G1+G2+GFP2 | Structure in FIG. 7A | 0.86 A | 4.8 V | 30.5 dB | 0.007 pF |
| G1+G2+GFP2+SFP2 | Structure in FIG. 8 | 0.86 A | 4.8 V | 32.3 dB | 0.005 pF |

As shown in Table 3, when Vgate2 applied to the second gate G2 is 2 V and the spacing L2 between the first gate field plate GFP1 and the second gate field plate GFP2 is 1.5 µm, it is found through simulation that, when the second source field plate SFP2 is disposed in the semiconductor component, a conductive structure of the second source field plate SFP2 may adjust electric field distribution between the second gate field plate GFP2 and the drain D, to reduce an electric field strength on a side that is of the second gate G2 and that is close to the drain D (the electric field strength may be reduced by about 55% in comparison with that of the semiconductor component shown in FIG. 2B), reduce a peak electric field of the semiconductor component, and further increase a breakdown voltage of the semiconductor component. In addition, after the electric field strength is reduced, a possibility that an electron is excited by the strong electric field to enter a surface state can be reduced, to suppress current collapse effect of the semiconductor component. In addition, the second source field plate SFP2 is disposed in the semiconductor component, and the second source field plate SFP2 can achieve shielding effect to some extent, and further extend a depletion region, to reduce the gate-drain parasitic capacitance Cgd between the first gate G1 and the drain D, and increase the small signal gain (the small signal gain may be increased by about 7 dB in comparison with that of the semiconductor component shown in FIG. 2B), a current gain cut-off frequency, and a power gain cut-off frequency of the semiconductor component.

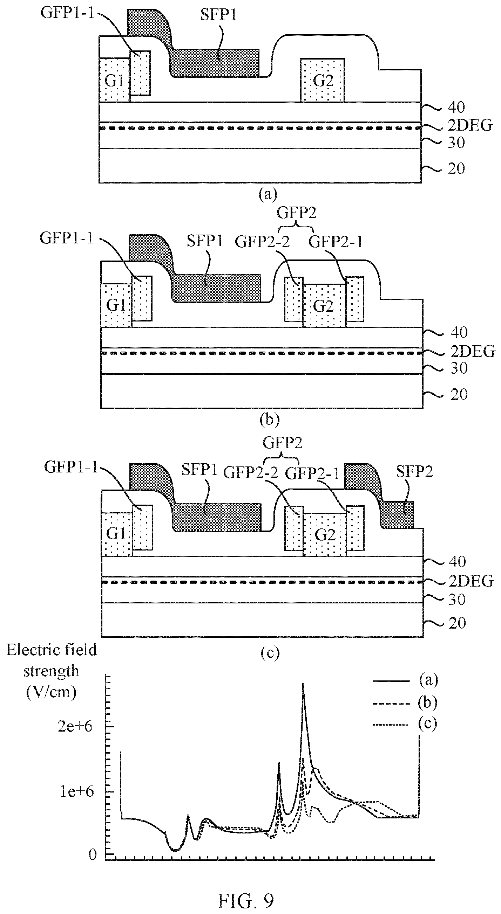

As shown in FIG. 9, after the second gate G2 is disposed between the first gate G1 and the drain D, as the second gate field plate GFP2 and the second source field plate SFP2 that correspond to the second gate G2 are added, the electric field strength between the first gate G1 and the drain D gradually reduces, and the breakdown voltage of the semiconductor component gradually increases. In FIG. 9, a vertical coordinate represents electric field strengths V/cm, and a horizontal coordinate represents positions in the semiconductor component.

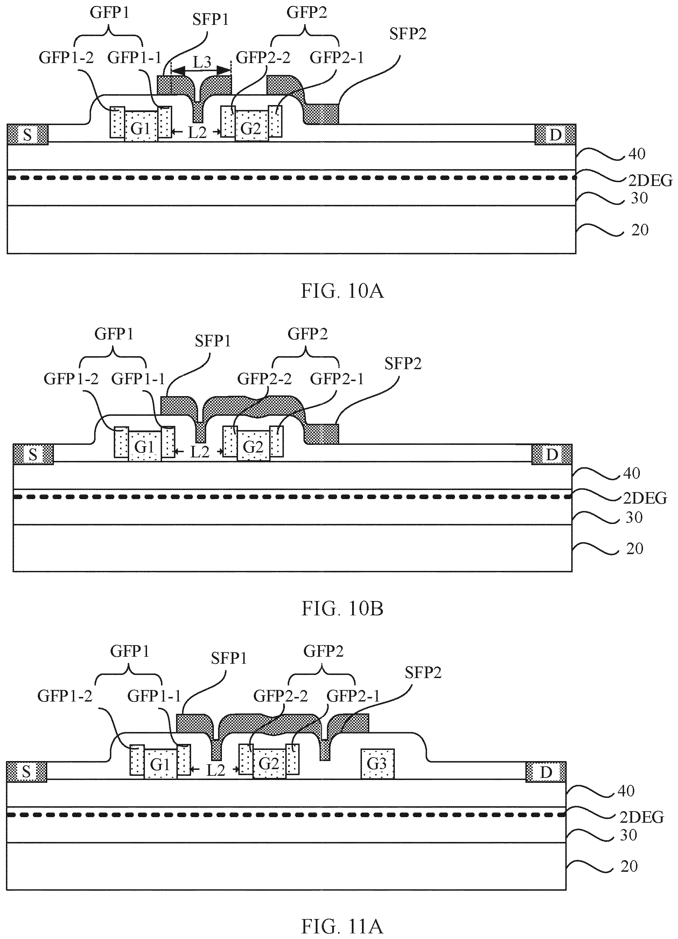

Alternatively, for example, as shown in FIG. 10A, the spacing L2 between the first gate field plate GFP1 and the second gate field plate GFP2 is less than the length L3 of the part that is of the first source field plate SFP1 and that is located between the first gate field plate GFP1 and the second gate field plate GFP2. In other words, the first source field plate SFP1 covers the second gate field plate GFP2. Alternatively, it is understood as that, in the direction perpendicular to the substrate 20, the first source field plate SFP1 overlaps the second gate field plate GFP2.

For example, as shown in FIG. 10A, in the direction perpendicular to the substrate 20, a side that is of the first source field plate SFP1 and that is close to the second gate G2 overlaps the second gate field plate GFP2.

It can be learned from Table 3 that, the semiconductor component including the first gate G1 and the second gate G2 shown in FIG. 3 can reduce the gate-drain parasitic capacitance Cgd of the semiconductor component, but may also reduce the saturation current of the semiconductor component. The spacing L2 between the first gate field plate GFP1 and the second gate field plate GFP2 is reduced, so that a reduction in the saturation current can be alleviated.

In an implementation, as shown in FIG. 10A, the first source field plate SFP1 is not connected to the second source field plate SFP2.

A preparation process of the first source field plate SFP1 is changed, so that the first source field plate SFP1 and the second source field plate SFP2 are not connected on the basis of reducing the spacing between the first gate field plate GFP1 and the second gate field plate GFP2.

**Table 4**

| Description | Solution | Saturation current | Knee-point voltage | Small signal gain | Cgd |
|---|---|---|---|---|---|
| G1 | Structure in FIG. 2B | 1.09 A | 7.2 V | 24.9 dB | 0.023 pF |
| G1+G2 | Structure in FIG. 3 | 0.82 A | 4.0 V | 30.1 dB | 0.009 pF |
| G1+G2+GFP2 | Structure in FIG. 7A | 0.86 A | 4.8 V | 30.5 dB | 0.007 pF |
| G1+G2+GFP2+SFP2 | Structure in FIG. 8 | 0.86 A | 4.8 V | 32.3 dB | 0.005 pF |
| G1+G2+GFP2+SFP2 | Structure in FIG. 10A | 0.97 A | 5.8 V | 31.4 dB | 0.007 pF |

As shown in Table 4, when the Vgate2 applied to the second gate G2 is 2 V, and the spacing L2 between the first gate field plate GFP1 and the second gate field plate GFP2 is 0.5 µm, it is found through simulation that, in comparison with the structure in FIG. 8, the structure in FIG. 10A shortens the spacing between the first gate field plate GFP1 and the second gate field plate GFP2, and the saturation current of the semiconductor component is significantly increased, but the knee-point voltage and the gate-drain parasitic capacitance Cgd are slightly increased, and the small signal gain of the semiconductor component is slightly decreased. Therefore, requirements of the small signal gain and the knee-point voltage of the semiconductor component may be comprehensively considered as needed, to properly set the spacing L2 between the first gate G1 and the second gate G2.

In another implementation, as shown in FIG. 10B, the first source field plate SFP1 is connected to the second source field plate SFP2.

The first source field plate SFP1 is connected to the second source field plate SFP2, so that the first source field plate SFP1 and the second source field plate SFP2 may be prepared by using an existing process without changing the preparation process of the first source field plate SFP1. However, as shown in Table 5, when the Vgate2 applied to the second gate G2 is 2 V and the spacing L2 between the first gate field plate GFP1 and the second gate field plate GFP2 is 0.5 µm, it is found through simulation that, in comparison with the structure in FIG. 10B, in the structure in FIG. 10A, the first source field plate SFP1 is connected to the second source field plate SFP2, and the small signal gain of the semiconductor component is slightly reduced.

**Table 5**

| Description | Solution | Saturation current | Knee-point voltage | Small signal gain | Cgd |
|---|---|---|---|---|---|
| G1 | Structure in FIG. 2B | 1.09 A | 7.2 V | 24.9 dB | 0.023 pF |
| G1+G2 | Structure in FIG. 3 | 0.82 A | 4.0 V | 30.1 dB | 0.009 pF |
| G1+G2+GFP2 | Structure in FIG. 7A | 0.86 A | 4.8 V | 30.5 dB | 0.007 pF |
| G1+G2+GFP2+SFP2 | Structure in FIG. 8 | 0.86 A | 4.8 V | 32.3 dB | 0.005 pF |
| G1+G2+GFP2+SFP2 | Structure in FIG. 10A | 0.97 A | 5.8 V | 31.4 dB | 0.007 pF |
| G1+G2+GFP2+SFP2 | Structure in FIG. 10B | 0.97 A | 5.8 V | 31.2 dB | 0.007 pF |

### Example 4 (according to the invention)

A difference between Example 4 and Example 1 to Example 3 lies in that, based on the semiconductor component provided in Example 1 to Example 3, a semiconductor component further includes a third gate G3.

A comparison with the semiconductor component provided in Example 3 is used as an example. As shown in FIG. 11A, the semiconductor component is provided, and the semiconductor component mainly includes: a substrate 20, a channel layer 30 and a barrier layer 40 that are sequentially stacked on the substrate 20, a source S and a drain D that are disposed side by side on the barrier layer 40, a first gate G1, a second gate G2, and the third gate G3 that are disposed on the barrier layer 40 and located between the source S and the drain D, a first gate field plate GFP1 and a second gate field plate GFP2, and a first source field plate SFP1 and a second source field plate SFP2.

As shown in FIG. 11A, the first gate G1, the second gate G2, and the third gate G3 are disposed on the barrier layer 40 and located between the source S and the drain D.

For example, as shown in FIG. 11A, the first gate G1, the second gate G2, and the third gate G3 are disposed on a surface of the barrier layer 40, and form a Schottky contact with the barrier layer 40.

The first gate G1, the second gate G2, and the third gate G3 may be formed, for example, by using photolithography and etching processes, and the first gate G1, the second gate G2, and the third gate G3 may be, for example, formed synchronously.

Certainly, it may be understood that a fourth gate or more gates may be further disposed between the third gate G3 and the drain D. This is not limited in this embodiment of this application. The gate may be properly disposed as needed.

Similar to a principle of adding the second gate G2 in Example 1, the third gate G3 is added between the second gate G2 and the drain D, and the third gate G3 can achieve shielding effect to some extent, to reduce a gate-drain parasitic capacitance Cgd between the first gate G1 and the drain D, and increase a small signal gain, a current gain cut-off frequency, and a power gain cut-off frequency of the semiconductor component.

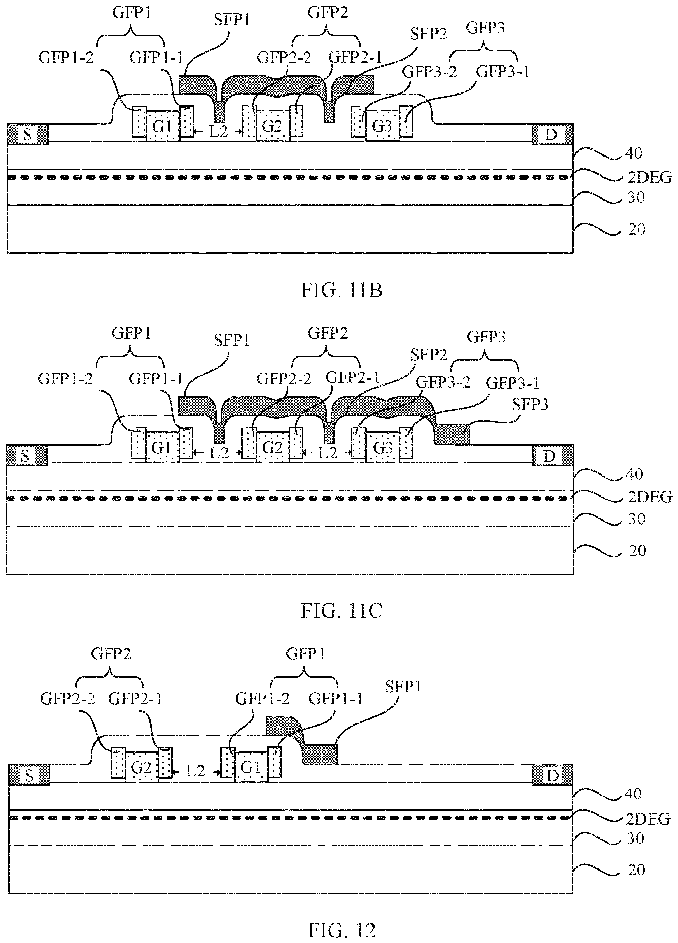

In some embodiments, as shown in FIG. 11B, the semiconductor component further includes a third gate field plate GFP3.

The third gate field plate GFP3 is at least partially located on a side that is of the third gate G3 and that is close to the drain D. The third gate field plate GFP3 is electrically connected to the third gate G3, and a spacing exists between the third gate field plate GFP3 and the barrier layer 40.

For example, the third gate field plate GFP3 includes only a part that is located on the side that is of the third gate G3 and that is close to the drain D, and the third gate field plate GFP3 is in contact with and connected to the third gate G3.

For example, the third gate field plate GFP3 and the third gate G3 are of an integrally formed structure, and are synchronously formed in a same preparation process.

Alternatively, for example, as shown in FIG. 11B, the third gate field plate GFP3 includes a first part GFP3-1 located on the side that is of the third gate G3 and that is close to the drain D and a second part GFP3-2 located on a side that is of the third gate G3 and that is close to the source S. The first part GFP3-1 and the second part GFP3-2 of the third gate field plate GFP3 are both in contact with and connected to the third gate G3.

For example, the first part GFP3-1 and the second part GFP3-2 of the third gate field plate GFP3 and the third gate G3 are of an integrally formed structure, and are synchronously formed in a same preparation process.

A shape of the third gate field plate GFP3 is not limited in this embodiment of this application, and a shape of the third gate field plate GFP3 shown in FIG. 11B is merely an example.

The third gate field plate GFP3 is disposed in the semiconductor component, so that an electric field strength of a region near the third gate G3 can be significantly reduced. Therefore, a possibility of breakdown of a material of the barrier layer 40 can be reduced, a breakdown voltage of the semiconductor component can be further increased, and performance of the semiconductor component can be ensured. In addition, the third gate field plate GFP3 is disposed in the semiconductor component, and the third gate field plate GFP3 can achieve the shielding effect to some extent, and further extend a depletion region, to reduce the gate-drain parasitic capacitance Cgd between the first gate G1 and the drain D, and increase the small signal gain, the current gain cut-off frequency, and the power gain cut-off frequency of the semiconductor component.

In some embodiments, as shown in FIG. 11C, the semiconductor component further includes a third source field plate SFP3. The third source field plate SFP3 is disposed on a side that is of the third gate field plate GFP3 and that is away from the substrate 20, and is electrically connected to the source S.

The third source field plate SFP3 covers the third gate field plate GFP3. In other words, in a direction perpendicular to the substrate 20 (or understood as a thickness direction of the substrate 20), the third source field plate SFP3 overlaps the third gate field plate GFP3.

For example, in the direction perpendicular to the substrate 20 (or understood as the thickness direction of the substrate 20), a side that is of the third source field plate SFP3 and that is close to the third gate field plate GFP3 overlaps the third gate field plate GFP3.

Alternatively, it is understood as that, on the side close to the third gate field plate GFP3, an orthographic projection of the third source field plate SFP3 on the substrate 20 overlaps an orthographic projection of the third gate field plate GFP3 on the substrate 20.

According to different structures of the second source field plate SFP2 and different distances between the second gate G2 and the third gate G3, the second source field plate SFP2 and the third source field plate SFP3 may be connected or may not be connected. FIG. 11C is shown by using an example in which the second source field plate SFP2 is connected to the third source field plate SFP3.

In some embodiments, structures of the first gate G1, the second gate G2, and the third gate G3 are the same, structures of the first gate field plate GFP1, the second gate field plate GFP2, and the third gate field plate GFP3 are the same, and structures of the first source field plate SFP1, the second source field plate SFP2, and the third source field plate SFP3 are the same. In this way, the structure is simple, and is easy to prepare.

As shown in Table 6, when Vgate2 applied to the second gate G2 is 2 V, a spacing L2 between the first gate field plate GFP1 and the second gate field plate GFP2 is 0.5 µm, and a spacing between the second gate field plate GFP2 and the third gate field plate GFP3 is 0.5 µm, it is found through simulation that, further increasing quantities of gates, gate field plates, and source field plates can further reduce the gate-drain parasitic capacitance Cgd, and increase the small signal gain of the semiconductor component.

**Table 6**

| Description | Solution | Saturation current | Knee-point voltage | Small signal gain | Cgd |
|---|---|---|---|---|---|
| G1 | Structure in FIG. 2B | 1.09 A | 7.2 V | 24.9 dB | 0.023 pF |
| G1+G2 | Structure in FIG. 3 | 0.82 A | 4.0 V | 30.1 dB | 0.009 pF |
| G1+G2+GFP2 | Structure in FIG. 7A | 0.86 A | 4.8 V | 30.5 dB | 0.007 pF |
| G1+G2+GFP2+SFP2 | Structure in FIG. 8 | 0.86 A | 4.8 V | 32.3 dB | 0.005 pF |
| G1+G2+GFP2+SFP2 | Structure in FIG. 10A | 0.97 A | 5.8 V | 31.4 dB | 0.007 pF |
| G1+G2+GFP2+SFP2 | Structure in FIG. 10B | 0.97 A | 5.8 V | 31.2 dB | 0.007 pF |
| G1+G2+GFP2+SFP2 +G3+GFP3+SFP3 | Structure in FIG. 11C | 0.84 A | 4.6 V | 33.5 dB | 0.002 pF |

### Example 5 (not falling under the scope of the invention)

A difference between Example 5 and Example 2 to Example 4 lies in that a first gate G1 is disposed close to a drain D relative to a second gate G2.

A comparison with the semiconductor component provided in Example 2 is used as an example. As shown in FIG. 12, the semiconductor component is provided, and the semiconductor component mainly includes: a substrate 20, a channel layer 30 and a barrier layer 40 that are sequentially stacked on the substrate 20, a source S and the drain D that are disposed side by side on the barrier layer 40, the first gate G1 and the second gate G2 that are disposed on the barrier layer 40 and located between the source S and the drain D, and a first gate field plate GFP1 and a first source field plate SFP1.

It should be emphasized that, as shown in FIG. 12, in the semiconductor component in this example, the first gate G1 is disposed between the second gate G2 and the drain D.

In this example, structures of the substrate 20, the channel layer 30 and the barrier layer 40, the source S and the drain D, the first gate G1 and the second gate G2, the first gate field plate GFP1, a second gate field plate GFP2, and the first source field plate SFP1 are the same as those in Example 2. For details, refer to related descriptions in Example 2. Details are not described herein again.

**Table 7**

| Description | Solution | Saturation current | Knee-point voltage | Small signal gain | Cgd |
|---|---|---|---|---|---|
| G1 | Structure in FIG. 2B | 1.09 A | 7.2 V | 24.9 dB | 0.023 pF |
| G1+G2 | Structure in FIG. 3 | 0.82 A | 4.0 V | 30.1 dB | 0.009 pF |
| G1+G2+GFP2 | Structure in FIG. 7A | 0.86 A | 4.8 V | 30.5 dB | 0.007 pF |
| G1+G2+GFP2+SFP2 | Structure in FIG. 8 | 0.86 A | 4.8 V | 32.3 dB | 0.005 pF |
| G1+G2+GFP2+SFP2 | Structure in FIG. 10A | 0.97 A | 5.8 V | 31.4 dB | 0.007 pF |
| G1+G2+GFP2+SFP2 | Structure in FIG. 10B | 0.97 A | 5.8 V | 31.2 dB | 0.007 pF |
| G1+G2+GFP2+SFP2 +G3+GFP3+SFP3 | Structure in FIG. 11C | 0.84 A | 4.6 V | 33.5 dB | 0.002 pF |
| G2+G1 | Structure in FIG. 12 | 0.97 A | 5.8 V | 31.2 dB | 0.007 pF |

As shown in Table 7, when Vgate2 applied to the second gate G2 is 2 V and the spacing L2 between the first gate field plate GFP1 and the second gate field plate GFP2 is 0.5 µm, it is found through simulation that, when the first source field plate SFP1 is disposed on the first gate G1 close to the drain D, and the second source field plate SFP2 is not disposed on the second gate G2 away from the drain D, the saturation current and the small signal gain of the semiconductor component are large. In comparison with the semiconductor component shown in FIG. 10B, on a premise that the saturation currents and the small signal gains of the semiconductor components are the same, the structure of the semiconductor component is simple, and the gate-source parasitic capacitance Cgs of the semiconductor component can be reduced.

It can be learned from the foregoing description of the semiconductor components provided in embodiments of this application that, according to an actual requirement on the semiconductor component, the quantity of gates, the quantity of gate field plates, the quantity of source field plates, the structure of the source field panel, and the spacing between the gate field plates are properly designed, so that radio frequency characteristics of the semiconductor component including the power (related to the saturation current), the small signal gain (related to the gate-drain parasitic capacitance Cgs), the efficiency (related to the knee-point voltage), and the like can be effectively balanced.

The semiconductor component provided in embodiments of this application may not only be used in a GaN HEMT component, but also be used in another III-V semiconductor component such as a GaAs (gallium arsenide) HEMT.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A semiconductor component, comprising:
a substrate (20);
a channel layer (30) and a barrier layer (40), sequentially stacked on the substrate (20);
a source (S) and a drain (D), disposed on the barrier layer (40);
a first gate (G1) and a second gate (G2), disposed on the barrier layer (40) and located between the source (S) and the drain (D), wherein the second gate (G2) is disposed between the first gate (G1) and the drain (D);
a first gate field plate (GFP1), at least partially disposed on a side that is of the first gate (G1) and that is close to the drain (D);
a second gate field plate (GFP2), at least partially disposed on a side that is of the second gate (G2) and that is close to the drain (D);
a first source field plate (SFP1), wherein the first source field plate (SFP1) is electrically connected to the source (S) and covers the first gate field plate (GFP1); and the first source field plate (SFP1) overlaps the first gate (G1) and does not cover the first gate (G1), or the first source field plate (SFP1) does not overlap the first gate (G1); **characterized in that** the semiconductor component further comprises
a second source field plate (SFP2), wherein the second source field plate (SFP2) is electrically connected to the source (S) and covers the second gate field plate (GFP2).

2. The semiconductor component according to claim 1, wherein the first source field plate (SFP1) covers the second gate field plate (GFP2).

3. The semiconductor component according to claim 1 or 2, wherein the first source field plate (SFP1) is connected to the second source field plate (SFP2).

4. The semiconductor component according to any one of claims 1 to 3, wherein a spacing (L1) between the first gate field plate (GFP1) and the second gate (G2) ranges from 0.5 µm to 2.7 µm.

5. The semiconductor component according to any one of claims 1 to 4, wherein the first gate field plate (GFP1) comprises a first part (GFP1-1) disposed on the side that is of the first gate (G1) and that is close to the drain (D) and a second part (GFP1-2) disposed on a side that is of the first gate (G1) and that is close to the source (S), and the first part (GFP1-1) and the second part (GFP1-2) are separately in contact with and connected to the first gate (G1).

6. The semiconductor component according to any one of claims 1 to 5, wherein the semiconductor component further comprises a third gate (G3), and the third gate (G3) is disposed between the second gate (G2) and the drain (D).

7. The semiconductor component according to claim 6, wherein the semiconductor component further comprises a third gate field plate (GFP3); and
the third gate field plate (GFP3) is at least partially disposed on a side that is of the third gate (G3) and that is close to the drain (D).

8. The semiconductor component according to claim 7, wherein the semiconductor component further comprises a third source field plate (GFP3), and the third source field plate covers the third gate field plate (GFP3).

9. An electronic device, comprising a semiconductor component and an antenna, wherein the semiconductor component is configured to amplify a radio frequency signal and output the amplified radio frequency signal to the antenna for radiation; and
the semiconductor component is the semiconductor component according to any one of claims 1 to 8.

## Patentansprüche

1. Halbleiterkomponente, umfassend:
ein Substrat (20);
eine Kanalschicht (30) und eine Sperrschicht (40), die aufeinanderfolgend auf dem Substrat (20) gestapelt sind;
eine Source (S) und einen Drain (D), die auf die Sperrschicht (40) angeordnet sind,
ein erstes Gate (G1) und ein zweites Gate (G2), die auf der Sperrschicht (40) angeordnet sind und sich zwischen der Source (S) und dem Drain (D) befinden, wobei das zweite Gate (G2) zwischen dem ersten Gate (G1) und dem Drain (D) angeordnet ist;
eine erste Gate-Feldplatte (GFP1), die mindestens teilweise auf einer Seite, die zu dem ersten Gate (G1) gehört und die nahe dem Drain (D) ist, angeordnet ist;
eine zweite Gate-Feldplatte (GFP2), die mindestens teilweise auf einer Seite, die zu dem zweiten Gate (G2) gehört und die nahe dem Drain (D) ist, angeordnet ist;
eine erste Source-Feldplatte (SFP1), wobei die erste Source-Feldplatte (SFP1) mit der Source (S) elektrisch verbunden ist und die erste Gate-Feldplatte (GFP1) bedeckt; und die erste Source-Feldplatte (SFP1) das erste Gate (G1) überlappt und das erste Gate (G1) nicht bedeckt oder die erste Source-Feldplatte (SFP1) das erste Gate (G1) nicht überlappt; **dadurch gekennzeichnet, dass** die Halbleiterkomponente ferner umfasst: eine zweite Source-Feldplatte (SFP2), wobei die zweite Source-Feldplatte (SFP2) mit der Source (S) elektrisch verbunden ist und die zweite Gate-Feldplatte (GFP2) bedeckt.

2. Halbleiterkomponente nach Anspruch 1, wobei die erste Source-Feldplatte (SFP1) die zweite Gate-Feldplatte (GFP2) bedeckt.

3. Halbleiterkomponente nach Anspruch 1 oder 2, wobei die erste Source-Feldplatte (SFP1) mit der zweiten Source-Feldplatte (SFP2) verbunden ist.

4. Halbleiterkomponente nach einem der Ansprüche 1 bis 3, wobei eine Beabstandung (L1) zwischen der ersten Gate-Feldplatte (GFP1) und dem zweiten Gate (G2) von 0,5 µm bis 2,7 µm reicht.

5. Halbleiterkomponente nach einem der Ansprüche 1 bis 4, wobei die erste Gate-Feldplatte (GFP1) einen ersten Teil (GFP1-1), der auf der Seite, die zu dem ersten Gate (G1) gehört und die nahe dem Drain (D) ist, angeordnet ist, und einen zweiten Teil (GFP1-2), der auf einer Seite, die zu dem ersten Gate (G1) gehört und die nahe der Source (S) ist, angeordnet ist, umfasst, und der erste Teil (GFP1-1) und der zweite Teil (GFP1-2) getrennt mit dem ersten Gate (G1) in Kontakt sind und damit verbunden sind.

6. Halbleiterkomponente nach einem der Ansprüche 1 bis 5, wobei die Halbleiterkomponente ferner ein drittes Gate (G3) umfasst und das dritte Gate (G3) zwischen dem zweiten Gate (G2) und dem Drain (D) angeordnet ist.

7. Halbleiterkomponente nach Anspruch 6, wobei die Halbleiterkomponente ferner eine dritte Gate-Feldplatte (GFP3) umfasst; und
die dritte Gate-Feldplatte (GFP3) mindestens teilweise auf einer Seite, die zu dem dritten Gate (G3) gehört und die nahe dem Drain (D) ist, angeordnet ist.

8. Halbleiterkomponente nach Anspruch 7, wobei die Halbleiterkomponente ferner eine dritte Source-Feldplatte (GFP3) umfasst und die dritte Source-Feldplatte die dritte Gate-Feldplatte (GFP3) bedeckt.

9. Elektronisches Gerät, umfassend eine Halbleiterkomponente und eine Antenne, wobei die Halbleiterkomponente konfiguriert ist zum Verstärken eines Funkfrequenzsignals und Ausgeben des verstärkten Funkfrequenzsignals zu der Antenne zur Ausstrahlung; und
die Halbleiterkomponente die Halbleiterkomponente nach einem der Ansprüche 1 bis 8 ist.

## Revendications

1. Composant semi-conducteur, comprenant :
un substrat (20) ;
une couche de canal (30) et une couche barrière (40), empilées séquentiellement sur le substrat (20) ;
une source (S) et un drain (D), disposés sur la couche barrière (40) ;
une première grille (G1) et une deuxième grille (G2), disposées sur la couche barrière (40) et situées entre la source (S) et le drain (D), dans lequel la deuxième grille (G2) est disposée entre la première grille (G1) et le drain (D) ;
une première plaque de champ de grille (GFP1), disposée au moins partiellement sur un côté de la première grille (G1) qui est près du drain (D) ;
une deuxième plaque de champ de grille (GFP2), disposée au moins partiellement sur un côté de la deuxième grille (G2) qui est près du drain (D) ;
une première plaque de champ de source (SFP1), dans lequel la première plaque de champ de source (SFP1) est connectée électriquement à la source (S) et couvre la première plaque de champ de grille (GFP1) ; et la première plaque de champ de source (SFP1) chevauche la première grille (G1) et ne couvre pas la première grille (G1), ou
la première plaque de champ de source (SFP1) ne chevauche pas la première grille (G1) ; **caractérisé en ce que** le composant semi-conducteur comprend en outre une seconde plaque de champ de source (SFP2), dans lequel la seconde plaque de champ de source (SFP2) est connectée électriquement à la source (S) et couvre la deuxième plaque de champ de grille (GFP2).

2. Composant semi-conducteur selon la revendication 1, **caractérisé en ce que** la première plaque de champ de source (SFP1) couvre la deuxième plaque de champ de grille (GFP2).

3. Composant semi-conducteur selon la revendication 1 ou 2, **caractérisé en ce que** la première plaque de champ de source (SFP1) est connectée à la seconde plaque de champ de source (SFP2).

4. Composant semi-conducteur selon l'une quelconque des revendications 1 à 3, **caractérisé en ce qu'**un espacement (L1) entre la première plaque de champ de grille (GFP1) et la deuxième grille (G2) s'étend sur 0,5 µm à 2,7 µm.

5. Composant semi-conducteur selon l'une quelconque des revendications 1 à 4, dans lequel la première plaque de champ de grille (GFP1) comprend une première partie (GFP1-1) disposée sur le côté de la première grille (G1) qui est près du drain (D) et une seconde partie (GFP1-2) disposée sur un côté de la première grille (G1) qui est près de la source (S), et la première partie (GFP1-1) et la seconde partie (GFP1-2) sont séparément en contact avec la première grille (G1) et connectées à celle-ci.

6. Composant semi-conducteur selon l'une quelconque des revendications 1 à 5, le composant semi-conducteur comprenant en outre une troisième grille (G3), et la troisième grille (G3) étant disposée entre la deuxième grille (G2) et le drain (D).

7. Composant semi-conducteur selon la revendication 6, le composant semi-conducteur comprenant en outre une troisième plaque de champ de grille (GPF3) ; et
la troisième plaque de champ de grille (GFP3) étant disposée au moins partiellement sur un côté de la troisième grille (G3) qui est près du drain (D).

8. Composant semi-conducteur selon la revendication 7, le composant semi-conducteur comprenant en outre une troisième plaque de champ de source (GPF3), et la troisième plaque de champ de source (GPF3) couvrant la troisième plaque de champ de grille (GPF3).

9. Dispositif électronique, comprenant un composant semi-conducteur et une antenne, dans lequel le composant semi-conducteur est configuré pour amplifier un signal radiofréquence et délivrer le signal radiofréquence amplifié à l'antenne en vue de son rayonnement ; et
le composant semi-conducteur est le composant semi-conducteur selon l'une quelconque des revendications 1 à 8.
